(19) Europäisches Patentamt
European Patent Office
Office européen des brevets

(11) EP 1 514 202 B1

(12) **EUROPÄISCHE PATENTSCHRIFT**

(45) Veröffentlichungstag und Bekanntmachung des Hinweises auf die Patenterteilung:
**04.01.2006 Patentblatt 2006/01**

(21) Anmeldenummer: 03759825.7

(22) Anmeldetag: **05.06.2003**

(51) Int Cl.:
**G06F 17/50** (2006.01)

(86) Internationale Anmeldenummer:
**PCT/DE2003/001862**

(87) Internationale Veröffentlichungsnummer:
**WO 2003/107225 (24.12.2003 Gazette 2003/52)**

(54) **VERFAHREN ZUM VERÄNDERN VON ENTWURFSDATEN FÜR DIE HERSTELLUNG EINES BAUTEILS SOWIE ZUGEHÖRIGER EINHEITEN**

METHOD FOR MODIFYING DESIGN DATA FOR THE PRODUCTION OF A COMPONENT AND CORRESPONDING UNITS

PROCEDE POUR MODIFIER DES DONNEES DE PLAN POUR LA PRODUCTION D'UN COMPOSANT ET UNITES ASSOCIEES

(84) Benannte Vertragsstaaten:
**DE FR GB**

(30) Priorität: **17.06.2002 DE 10226915**

(43) Veröffentlichungstag der Anmeldung:
**16.03.2005 Patentblatt 2005/11**

(73) Patentinhaber: **Infineon Technologies AG**
**81669 München (DE)**

(72) Erfinder:
• **KOEDER, Ottmar**
**83624 Otterfing (DE)**
• **MELZNER, Hanno**
**82054 Sauerlach (DE)**

(74) Vertreter: **Kindermann, Peter et al**
**Kindermann Patentanwälte**
**Postfach 100234**
**85593 Baldham (DE)**

(56) Entgegenhaltungen:
US-A- 5 914 887     US-A- 6 052 677
US-B1- 6 360 191     US-B1- 6 363 519

• AKTUNA M, RUTENBAR R A, CARLEY L R: "Device-Level Early Floorplanning Algorithms for RF Circuits" IEEE TRANSACTIONS ON COMPUTER-AIDED DESIGN OF INTEGRATED CIRCUITS AND SYSTEMS, Bd. 18, Nr. 4, April 1999 (1999-04), Seiten 375-388, XP002261206

• ARSLAN T ET AL: "STRUCTURAL CELL-BASED VLSI CIRCUIT DESIGN USING A GENETIC ALGORITHM" 1996 IEEE INTERNATIONAL SYMPOSIUM ON CIRCUITS AND SYSTEMS (ISCAS). CIRCUITS AND SYSTEMS CONNECTING THE WORLD. ATLANTA, MAY 12 - 15, 1996, IEEE INTERNATIONAL SYMPOSIUM ON CIRCUITS AND SYSTEMS (ISCAS), NEW YORK, IEEE, US, Bd. 4, 12. Mai 1996 (1996-05-12), Seiten 308-311, XP000704598 ISBN: 0-7803-3074-9

• AHMAD I ET AL: "DESIGN-SPACE EXPLORATION FOR HIGH-LEVEL SYNTHESIS" PROCEEDINGS OF THE ANNUAL INTERNATIONAL PHOENIX CONFERENCE ON COMPUTERS AND COMMUNICATIONS. PHOENIX, APR. 12 - 15, 1994, NEW YORK, IEEE, US, Bd. CONF. 13, 12. April 1994 (1994-04-12), Seiten 491-496, XP000462601

• POWELL D J ET AL: "ENGENEOUS DOMAIN INDEPENDENT, MACHINE LEARNING FOR DESIGN OPTIMIZATION" PROCEEDINGS OF THE INTERNATIONAL CONFERENCE ON GENETIC ALGORITHMS. ARLINGTON, JUNE 4 - 7, 1989, SAN MATEO, MORGAN KAUFMANN, US, Bd. CONF. 3, 4. Juni 1989 (1989-06-04), Seiten 151-159, XP000236324

- ZHUANG N ET AL: "IMPROVED VARIABLE ORDERING OF BDDS WITH NOVEL GENETIC ALGORITHM" 1996 IEEE INTERNATIONAL SYMPOSIUM ON CIRCUITS AND SYSTEMS (ISCAS). CIRCUITS AND SYSTEMS CONNECTING THE WORLD. ATLANTA, MAY 12 - 15, 1996, IEEE INTERNATIONAL SYMPOSIUM ON CIRCUITS AND SYSTEMS (ISCAS), NEW YORK, IEEE, US, Bd. 3, 12. Mai 1996 (1996-05-12), Seiten 414-417, XP000688881 ISBN: 0-7803-3074-9
- AKIO SAKAMOTO ET AL: "A MODIFIED GENETIC CHANNEL ROUTER" IEICE TRANSACTIONS ON FUNDAMENTALS OF ELECTRONICS, COMMUNICATIONS AND COMPUTER SCIENCES, INSTITUTE OF ELECTRONICS INFORMATION AND COMM. ENG. TOKYO, JP, Bd. E77-A, Nr. 12, 1. Dezember 1994 (1994-12-01), Seiten 2076-2083, XP000497867 ISSN: 0916-8508
- KOSAK C ET AL: "A PARALLEL GENETIC ALGORITHM FOR NETWORK-DIAGRAM LAYOUT" PROCEEDINGS OF THE INTERNATIONAL CONFERENCE ON GENETIC ALGORITHMS. SAN DIEGO, JULY 13 - 16, 1991, SAN MATEO, MORGAN KAUFMANN, US, Bd. CONF. 4, 13. Juli 1991 (1991-07-13), Seiten 458-465, XP000260135
- BRAND D: "Hill climbing with reduced search space (logic optimization)" COMPUTER-AIDED DESIGN, 1988. ICCAD-88. DIGEST OF TECHNICAL PAPERS., IEEE INTERNATIONAL CONFERENCE ON SANTA CLARA, CA, USA 7-10 NOV. 1988, WASHINGTON, DC, USA,IEEE COMPUT. SOC. PR, US, 7. November 1988 (1988-11-07), Seiten 294-297, XP010013371 ISBN: 0-8186-0869-2
- VECCHI M P, KIRKPATRICK S: "Global wiring by simulated annealing" IEEE TRANSACTION ON COMPUTER-AIDED DESIGN OF INTEGRATED CIRCUITS AND SYSTEMS, Bd. CAD2, Nr. 4, Oktober 1983 (1983-10), Seiten 215-222, XP009021045

**Beschreibung**

Die Erfindung betrifft ein Verfahren, bei dem Entwurfsdaten vorgegeben werden, die einen geometrischen Entwurf für ein Bauteil festlegen, z.B. für eine integrierte Schaltungsanordnung oder für ein anderes elektronisches Bauteil.

Die Entwurfsdaten sind beispielsweise Rasterdaten, die einzelne Bildpunkte in einem Raster festlegen, oder Vektordaten, die den Entwurf mit Hilfe von Vektoren bestimmter Länge und bestimmter Richtung festlegen. Der Entwurf ist im einfachsten Fall zweidimensional, z.B. bei einem Entwurf für eine Lage einer integrierten Schaltung. Ein dreidimensionaler Entwurf wird bspw. zum Festlegen des Zusammenhangs zwischen verschiedenen Lagen genutzt. Durch den geometrischen Entwurf wird die äußere Form von Elementen des Bauteils festgelegt, z.B. der Umriss einer Leiterbahn oder die Form eines Kontaktloch-Leiterbahn-Bereiches.

Es ist Aufgabe der Erfindung, ein einfaches Verfahren zum Verändern von Entwurfsdaten anzugeben, das insbesondere zur Optimierung eines Entwurfs geeignet ist. Außerdem sollen zugehörige Einheiten angegeben werden.

Die auf das Verfahren bezogene Aufgabe wird durch die im Patentanspruch 1 angegebenen Verfahrensschritte gelöst. Weiterbildungen sind in den Unteransprüchen angegeben.

Bei dem erfindungsgemäßen Verfahren werden automatisch mehrere Zyklen der folgenden Verfahrensschritte durchgeführt:

- aus den Entwurfsdaten werden veränderte Entwurfsdaten erzeugt und gespeichert, die einen im Vergleich zu dem geometrischen Entwurf der Entwurfsdaten lokal veränderten geometrischen Entwurf festlegen.
- Aus den veränderten Entwurfsdaten wird für den veränderten Entwurf ein Bewertungsmaß ermittelt.
- Anschließend wird das Bewertungsmaß für den veränderten Entwurf mit einem Bewertungsmaß für den zu verändernden Entwurf verglichen.
- Abhängig vom Vergleichsergebnis werden die unveränderten Entwurfsdaten beibehalten oder durch die veränderten Entwurfsdaten ersetzt.
- Im nächsten Zyklus werden die veränderten Entwurfsdaten als zu verändernde Entwurfsdaten genutzt. Das für die veränderten Entwurfsdaten berechnete Bewertungsmaß wird als Bewertungsmaß für den zu verändernden Entwurf genutzt.

Durch das erfindungsgemäße Verfahren lässt sich das bisher überwiegend manuell durchgeführte Optimieren eines Entwurfs automatisch durchführen. Durch das automatische Bewerten der Entwürfe im Rahmen der Optimierung lässt sich auf einfache Art eine automatische Optimierung erzielen.

Durch die lokale Veränderung werden bisher erreichte Vorzüge des Entwurfs im Wesentlichen beibehalten. So werden die außerhalb des lokalen Bereiches liegenden Teile des Entwurfs bei einem Zyklus nicht verändert. Die innerhalb eines lokal zu verändernden Bereiches liegenden Teile lassen sich so verändern, dass bei jedem Zyklus nur vergleichsweise moderat geändert wird.

Die Bewertungsmaße hängen von der Art des Bauteils und der konkreten Struktur des Bauteils ab. Es lässt sich ein einziges Bewertungsmaß berücksichtigen oder ein Gesamtbewertungsmaß, das mehrere Bewertungsmaße einbezieht, die auch zueinander gegenläufige Anforderungen bewerten können.

Der Vergleich der Bewertungsmaße ist im einfachsten Fall beispielsweise die Bildung einer Differenz. Jedoch lassen sich auch andere Vergleichsmethoden nutzen.

Für das Beibehalten bzw. für das Ersetzen der unveränderten Entwurfsdaten werden geeignete Regeln vorgegeben. Diese Regeln sind entweder deterministisch oder von einer Zufallsgröße abhängig. Das Berücksichtigen von Zufallsgrößen bietet die Möglichkeit, auch eine kleine Einbuße bei einem Zyklus hinzunehmen, um den Gesamtentwurf letztlich doch um ein Maß zu verbessern, das nicht erreicht werden könnte, wenn auch bei jedem Zyklus eine Verbesserung auftreten muss.

Bei einer Weiterbildung des erfindungsgemäßen Verfahrens wird ein Bereich für die lokale Veränderung und die Größe dieses Bereiches ohne Nutzung einer Zufallsfunktion ermittelt bzw. vorgegeben. Alternativ lässt sich der Bereich und seine Größe jedoch auch unter Nutzung einer Zufallsfunktion ermitteln. Durch geeignete Wahl des Verfahrens zum Ermitteln des Bereiches und seiner Größe lässt sich abhängig von dem zu verbessernden Entwurf die für eine bestimmte Verbesserung benötigte Zyklenanzahl verringern.

Bei einer nächsten Weiterbildung wird ein Bereich für die lokale Veränderung und die Größe dieses Bereiches gemäß einer Gleichverteilung gewählt. Durch diese Maßnahme wird sichergestellt, dass alle Bereiche des Entwurfs gleichermaßen in das Verfahren einbezogen werden. Alternativ wird der Bereich oder seine Größe mit einer Begünstigung von Bereichen bzw. Größen ausgewählt, die die Veränderung des Bewertungsmaßes hin zum Ziel des Verfahrens besonders beeinträchtigen. Soll das Bewertungsmaß im Verlauf des Verfahrens beispielsweise verkleinert werden, so werden Bereiche begünstigt, in denen das Bewertungsmaß besonders hoch ist. Auch diese Maßnahme führt dazu, dass die Anzahl der für eine bestimmte Verbesserung erforderlichen Zyklen sinkt.

Bei einer anderen Weiterbildung des Verfahrens zum Verändern von Entwurfsdaten wird für das Erzeugen der veränderten Entwurfsdaten in dem durch die zu verändernden Entwurfsdaten festgelegten Entwurf ein Bereich ausgewählt, der beispielsweise eine rechteckige Fläche hat. Danach werden die Entwurfsdaten ermittelt, die den Entwurf in den ausgewählten Bereichen betreffen. Die ermittelten Entwurfsdaten werden gemäß einer vorgegebenen Funktion verändert, die eine Geometrieveränderung des Entwurfs in dem ausgewählten Bereich bewirkt. Auf diese Art und Weise lassen sich die Entwurfsdaten auf einfache Art verändern.

Die Geometrieveränderung lässt sich mit Hilfe von einfachen Verfahren der Bildbearbeitung durchführen, beispielsweise mit Hilfe von Filterfunktionen oder mit Hilfe einfacher geometrischer Funktionen, wie z.B. eine Verschiebung, eine Spiegelung, eine Drehung, eine Dehnung oder eine Stauchung. Eine einfache Geometrieveränderung besteht auch darin, dass der Entwurf des ausgewählten Bereiches durch den Entwurf eines geometrisch ähnlichen Bereiches an einer anderen Stelle des zu verändernden Entwurfs oder durch dem ausgewählten Entwurfsteil ähnliche vorgegebene Entwurfsteile ersetzt wird. Die Geometrieveränderung ist nicht auf die Größe des zu verändernden Entwurfs beschränkt. Wird beispielsweise auch eine Vergrößerung der Gesamtfläche zugelassen, so lässt sich das Gesamtbewertungsmaß in vielen Fällen trotzdem verbessern.

Wird bei einer Weiterbildung die Vorgabe für die Geometrieveränderung unter Nutzung einer Zufallsfunktion ermittelt, so müssen keine komplizierten Regeln zur Veränderung des Entwurfs vorgegeben werden. Durch Probieren und die anschließende Bewertung der Veränderung lassen sich auf einfache Weise Verbesserungen erzielen.

Als Bewertungsmaß für elektronische Bauteile sind insbesondere die folgenden Bewertungsmaße geeignet:

- die kritische Fläche bezüglich Kurzschlüssen,
- die kritische Fläche bezüglich Unterbrechungen,
- die Anzahl von Ecken bzw. die Anzahl von Kanten in dem Entwurf,
- die Strombelastbarkeit,
- Koppelkapazitäten,
- die Überlappung von Elementen, sowie
- die Gesamtfläche des Entwurfs.

Die kritischen Flächen werden auch als "critical areas" bezeichnet und werden z.B. unter Annahme kreisförmiger Defekte einer vorgegebenen Größenverteilung ermittelt. Die Größenverteilung wird so gewählt, dass bei der Herstellung des Bauelementes auftretende Defekte möglichst gut nachgebildet werden.

Bei einer Ausgestaltung werden simultan mehrere Entwürfe übereinanderliegender Leitbahnebenen gemäß dem erfindungsgemäßen Verfahren bearbeitet. Auf diese Weise lassen sich die Entwürfe besonders gut beispielsweise hinsichtlich der Koppelkapazitäten oder der Überlappungen zwischen Leitbahnen optimieren.

Bei einer nächsten Weiterbildung ist das Bewertungsmaß ein Gesamtbewertungsmaß, das aus mindestens zwei verschiedenen Bewertungsmaßen ermittelt wird. Bei einer nächsten Weiterbildung werden Wichtungsfaktoren vorgegeben, die bei der Ermittlung des Gesamtbewertungsmaßes aus den einzelnen Bewertungsmaßen verwendet werden. Durch diese Maßnahme lassen sich verschiedene Bewertungsmaße unterschiedlich stark bei der Durchführung des Verfahrens berücksichtigen. Auch ist dadurch die Möglichkeit gegeben, dass bestimmte Bewertungsmaße am Anfang der Durchführung des Verfahrens einen großen Einfluss auf die Veränderungen haben, der dann im Verlauf des Verfahrens zugunsten des Einflusses von Bewertungsmaßen mit einem kleinen Wichtungsfaktor zurückgeht. Die Wichtung wird linear oder auch gemäß einer nicht linearen Funktion ausgeführt.

Bei einer nächsten Weiterbildung wird die Entscheidung über das Ersetzen der unveränderten Ergebnisdaten abhängig von einer Zufallsfunktion durchgeführt. Diese Maßnahme gestattet es, in einem Zyklus nicht nur eine Veränderung durchzuführen, die sofort zu einer Verbesserung des Entwurfs führen muss. So lassen sich auch Veränderungen, die zu keiner oder nur zu einer unwesentlichen Verschlechterung des Bewertungsmaßes führen, gemäß einer bestimmten Wahrscheinlichkeit übernehmen.

Bei einer nächsten Weiterbildung wird die Abhängigkeit der Entscheidung für oder gegen eine Übernahme von der Zufallsfunktion abhängig von der Zyklenanzahl verringert. Das bedeutet, dass am Anfang des Verfahrens häufiger bspw. auch die Übernahme von Teilentwürfen zugelassen wird, die zu einer Verschlechterung führen als am Ende des Verfahrens. Solche Verfahren werden auch als simulierten Abkühlen oder als simulated annealing bezeichnet.

Bei einer anderen Weiterbildung des erfindungsgemäßen Verfahrens wird für die Entwürfe ein Rastermaß gewählt, das gleich der Breite eines Maskenschreibstrahls ist, der zur Übertragung des Entwurfs auf eine Lithografiemaske genutzt wird, z.B. auf eine Fotomaske. Damit lassen sich die mit Hilfe des Verfahrens erzeugten Entwürfe ohne zusätzliche Maßnahme einfach auf die Fotomaske übertragen. Bei einer Alternative wird jedoch für die Entwürfe ein Rastermaß gewählt, das kleiner als die Breite des Maskenschreibstrahls ist. Auch eine solche Vorgehensweise führt unter Umständen zu Masken, die zur Belichtung sehr gut geeignet sind.

Die Erfindung betrifft außerdem eine Datenverarbeitungsanlage und ein Programm, die zur Durchführung des erfindungsgemäßen Verfahrens oder einer seiner Weiterbildungen geeignet sind. Damit gelten die oben genannten technischen Wirkungen auch für die Datenverarbeitungsanlage und das Programm.

Als Bauteil, dessen Entwurf mit Hilfe des erfindungsgemäßen Verfahrens verbessert wird, ist insbesondere geeignet:

- eine integrierte Schaltungsanordnung, insbesondere eine Teilschaltung, die in größeren Schaltungsanordnungen sehr oft, z.B. mehr als hundert mal oder sogar mehr als tausend mal vorkommt. Dies betrifft die Schaltung einer Speicherzelle, eines Kontaktlochbereichs oder einer Logikgrundfunktion, z.B. eines ODER-Gatters oder eines NAND-Gatters,
- ein Display, insbesondere ein Flachbildschirm,
- ein Sensor,
- ein mikromechanisches Bauteil,
- eine Leiterplatte, sowie
- ein elektrisches oder elektronisches Bauteil auf Folienbasis.

Jedoch werden auch Bauteile aus anderen technischen Bereichen mit Hilfe des erfindungsgemäßen Verfahrens optimiert.

Im Folgenden werden Ausführungsbeispiele der Erfindung an Hand der beiliegenden Zeichnungen erläutert. Darin zeigen:

Figuren 1A bis 1C    die Optimierung eines Entwurfs gemäß einem ersten Ausführungsbeispiel,

Figur 2    das Ergebnis einer Optimierung gemäß einem zweiten Ausführungsbeispiel,

Figur 3    Verfahrensschritte zur Optimierung eines Entwurfs,

Figur 4    den Verlauf einer Bewertungsfunktion für die Stromdichte in einer Leitbahn,

Figur 5    den Verlauf einer Bewertungsfunktion für eine Überlappung zwischen einer Leitbahn und einem Kontaktloch, und

Figur 6    Funktionseinheiten einer elektronischen Schaltung zum Optimieren des Entwurfs.

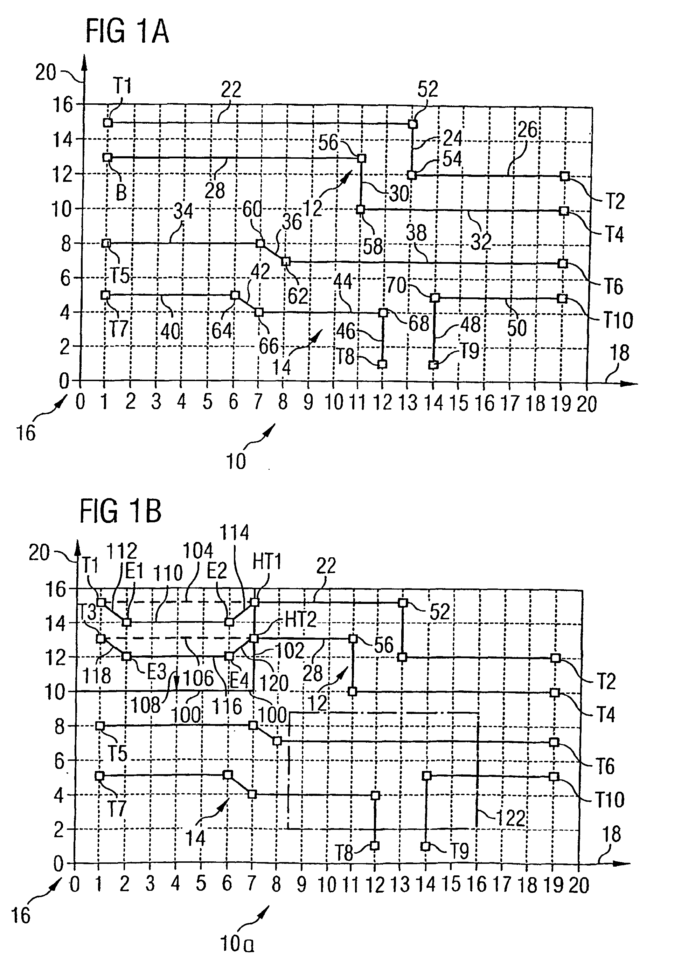

Figur 1A zeigt einen Entwurf 10 für einen Teil einer integrierten Schaltungsanordnung. Der Entwurf 10 enthält den Umriss 12 einer unverzweigten Leitbahn und den Umriss 14 einer T-förmig verzweigten Leitbahn. Die Umrisse 12 und 14 sind in einem Koordinatensystem 16 dargestellt, das eine x-Achse 18 zur Darstellung eines Rastermaßes in x-Richtung und eine y-Achse 20 zur Darstellung eines Rastermaßes in y-Richtung hat. Der Entwurf 10 hat die Größe von zwanzig Rasterpunkten in x-Richtung und von sechzehn Rasterpunkten in y-Richtung.

Der Umriss 12 wird im Entwurf 10 durch drei Kantenlinien 22, 24 und 26, die von einem Endpunkt T1 bis zu einem Endpunkt T2 verlaufen, und durch drei Kantenlinien 28, 30 und 32, die von einem Endpunkt T3 bis T4 verlaufen gebildet. Der Umriss 14 wird durch drei Kantenlinien 34, 36 und 38, die von einem Endpunkt T5 bis zu einem Endpunkt T6 verlaufen, durch vier Kantenlinien 40 bis 46, die von einem Endpunkt T7 bis zu einem Endpunkt T8 verlaufen, sowie durch zwei Kantenlinien 48, 50, die von einem Endpunkt T9 zu einem Endpunkt T10 verlaufen, dargestellt. Zehn Eckpunkte 52 bis 70 liegen jeweils an der Berührungsstelle von zwei Kantenlinien 22 bis 50 mit verschiedenen Richtungen. Die Kantenlinien 22 bis 50 liegen entweder in x-Richtung, in y-Richtung oder in einem Winkel von 45 Grad oder von 135 Grad zur x-Achse 20.

Die Endpunkte T1 und T2 stellen einen linken Anschluss der durch den Umriss 12 dargestellten unverzweigten Leitbahn dar. Die Endpunkte T2 und T4 stellen einen rechten Anschluss der unverzweigten Leitbahn dar.

Die Endpunkte T5 und T7 stellen einen linken Anschluss der durch den Umriss 14 dargestellten verzweigten Leitbahn dar. Die Endpunkte T6 und T10 stellen einen linken Anschluss der verzweigten Leitbahn dar. Die Endpunkte T8 und T9 stellen einen unteren Anschluss der Leitbahn dar, wobei die Richtungen auf den Entwurf 10 bezogen sind, wie er in der Figur 1B dargestellt ist.

Die Lage der Endpunkte T1 bis T10 wird im Ausführungsbeispiel fest vorgegeben. Das bedeutet, dass bei der Optimierung des Entwurfs 10 die Umrisse 12 und 14 nur innerhalb des zwischen den Endpunkten T1 bis T10 liegenden Bereiches verändert werden dürfen. Die Lage der Endpunkte T1 bis T6 ist dagegen fest.

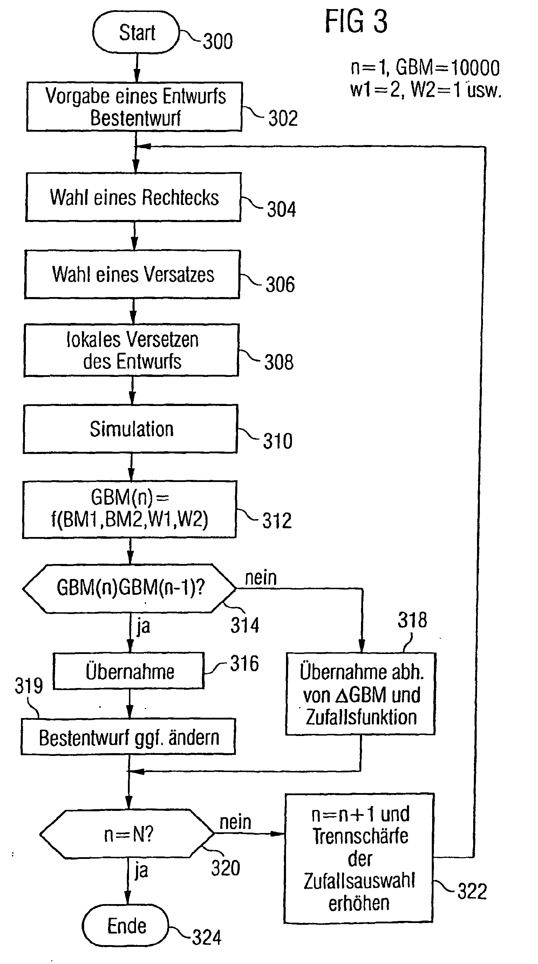

Figur 1B zeigt einen Entwurf 10a mit einer Verschiebung in einem Verschiebungsbereich 100. Die Verschiebung entsteht bei der Durchführung des unten an Hand der Figur 3 erläuterten Optimierungsverfahrens in einem ersten Zyklus. Der Verschiebungsbereich 100 liegt in der oberen linken Ecke des Entwurfs 10 und hat in x-Richtung eine Länge von sieben Rasterpunkten sowie in y-Richtung 20 eine Länge von sechs Rasterpunkten. Innerhalb des Verschiebungsbereiches 100 liegen die Endpunkte T1 und T3. Eine rechte Randlinie 102 des Bereiches 100 schneidet die Kantenlinie 22 an einem Hilfspunkt HT1, der etwa in der Mitte der Kantenlinie 22 liegt. Die rechte Randlinie 102 schneidet die parallel zur Kantenlinie 22 liegende Kantenlinie 28 in einem Hilfspunkt HT2, der etwas rechts des Mittelpunktes der Kantenlinie 28 liegt. Innerhalb des Bereiches 100 sind die Kantenlinien 22 und 28 durch gestrichelte Linien 104 und 106 dargestellt, da die Kantenlinien 22 und 28 dort im ersten Optimierungszyklus in eine zufällig gewählte Richtung und um eine zufällig gewählte Anzahl von Rasterpunkten verschoben werden.

Im Ausführungsbeispiel sei angenommen, dass im ersten Verfahrensschritt die zufällig gewählte Richtung eine Richtung ist, die entgegengesetzt der y-Richtung liegt. Das zufällig gewählte Rastermaß hat den Wert Eins, siehe Verschiebungspfeil 108. Aufgrund der Verschiebung im Verschiebungsbereich 100 wird die gestrichelte Linie 104 um einen Rasterpunkt entgegen der y-Richtung 20 verschoben. Der Endpunkt T1 und der Hilfspunkt HT1 bleiben aber an ihrer ursprünglichen Lage unverändert. Aus der gestrichelten Linie 104 entsteht eine neue Kantenlinie 110, die parallel zur gestrichelten Linie 104 liegt und an Eckpunkten E1 und E2 endet. Die Eckpunkte E1 und E2 werden dann durch geneigte Kantenlinien 112 und 114 mit dem Endpunkt T1 bzw. dem Hilfspunkt HT1 gitterkonform verbunden d.h. unter Beibehaltung von Nachbarschaftsbeziehungen.

Auf gleiche Weise wird die gestrichelte Linie 106 verschoben. Dabei entsteht eine parallel zur gestrichelten Linie 106 um einen Rasterpunkt nach unten verschobene Kantenlinie 116, die zwischen zwei Eckpunkten E3 und E4 liegt. Anschließend wird eine Kantenlinie 118 erzeugt, die von dem Endpunkt T3 zum Eckpunkt E3 verläuft. Eine Kantenlinie 120 wird so erzeugt, dass sie vom Endpunkt E4 zum Hilfspunkt HT2 verläuft.

Durch die mit Hilfe des Verschiebungspfeils 108 angedeutete Verschiebungsoperation wurde der Umriss 12 der unverzweigten Leitbahn innerhalb des Bereiches 100 um einen Rasterpunkt nach unten verschoben, ohne dabei die Breite des Umrisses 12 zu verändern. Die Verschiebung wurde so ausgeführt, dass sowohl Endpunkte T1 bis T10 als auch Hilfspunkte HT1 und HT2, an denen Kantenlinien 22 bis 50 des Entwurfs 10 Randlinien 102 des Verschiebungsbereiches 100 schneiden, in ihrer Lage unverändert bleiben. Ausgehend von dem veränderten Entwurf 10a werden die unten an Hand der Figur 3 erläuterten Schritte zur Bewertung des veränderten Entwurfs 10a ausgeführt. Wird festgestellt, dass eine Verbesserung des Entwurfs 10 eingetreten ist, so wird der Entwurf 10 immer mit der im Bereich 100 erzeugten Veränderung für das weitere Optimierungsverfahren übernommen. Ist dagegen keine Verbesserung eingetreten, so wird die weitere Optimierung meistens ohne die im Verschiebungsbereich 100 erzeugte Veränderung durchgeführt, d.h. nochmals ausgehend vom Entwurf 10.

In einem nächsten Zyklus des Optimierungsverfahrens wird wieder zufällig ein Verschiebungsbereich ausgewählt, z.B. ein Verschiebungsbereich 122, der weiter in der Mitte des Entwurfs 10 bzw. 10a liegt als der Verschiebungsbereich 100. Der Verschiebungsbereich 122 ist auch etwas größer als der Verschiebungsbereich 100. Im Verschiebungsbereich 122 wird wiederum eine Verschiebung von Kantenlinien entlang einer zufällig gewählten Richtung und um eine zufällig gewählte Anzahl von Rasterpunkten ausgeführt.

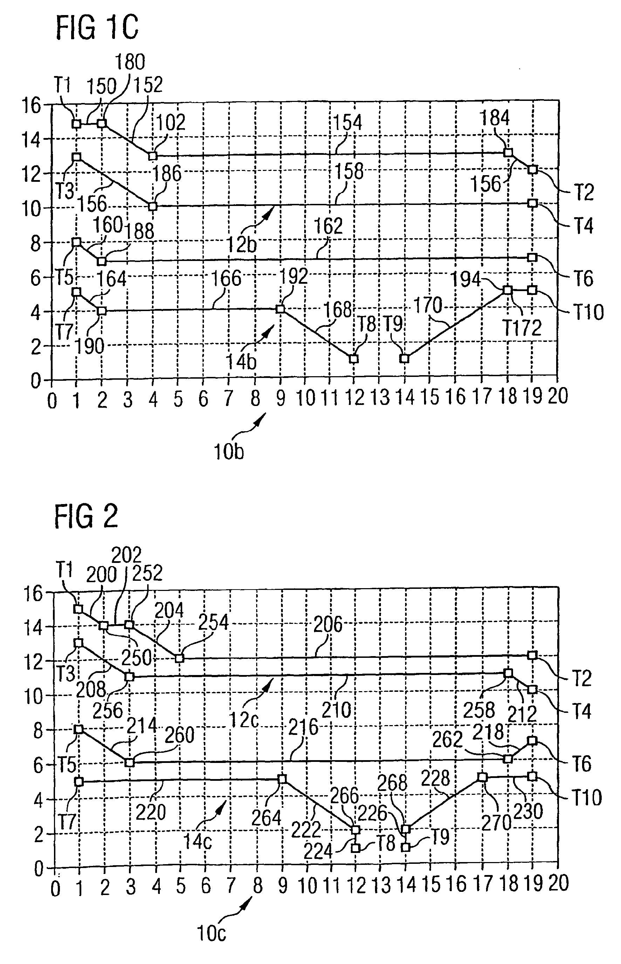

Figur 1C zeigt einen Entwurf 10b, der aus dem Entwurf 10 mit Hilfe des Optimierungsverfahrens erzeugt worden ist, das unten an Hand der Figur 3 erläutert wird. Bei der Optimierung wurden Kurzschlüsse doppelt so hoch gewichtet, wie Unterbrechungen. Die Umrisse 12 und 14 der Leitbahnen haben sich verändert, wobei Umrisse 12b und 14b entstanden sind. Vier Kantenlinien 150 bis 156 liegen nun zwischen den Endpunkten T1 und T2. Zwischen den Endpunkten T3 und T4 liegen nur noch zwei Kantenlinien 156 und 158.

Der Umriss 14b für die verzweigte Leitbahn wird durch zwei Kantenlinien 160 und 162 zwischen den Endpunkten T5 und T6, durch drei Kantenlinien 164, 166 und 168 zwischen den Endpunkten T7 und T8 sowie durch zwei Kantenlinien 170 und 172 zwischen den Endpunkten T9 und T10 gebildet. Im Entwurf 10b gibt es nur noch acht Eckpunkte 180 bis 194. Dadurch vereinfacht sich die Maskenfertigung.

Figur 2 zeigt einen Entwurf 10c, der aus dem Entwurf 10 bei der Durchführung eines Optimierungsverfahrens gemäß Figur 3 entstanden ist, wobei Kurzschlüsse zehnmal so hoch gewichtet worden sind wie Unterbrechungen. Ein Umriss 12c der unverzweigten Leitbahn wird nun durch vier Kantenlinien 200 bis 206 zwischen den Endpunkten T1 und T2 sowie durch drei Kantenlinien 208, 210 und 212 zwischen den Endpunkten T3 und T4 dargestellt. Ein Umriss 14c der verzweigten Leitbahn wird durch drei Kantenlinien 214, 216, 218 zwischen den Endpunkten T5 und T6, durch drei Kantenlinien 220, 222 und 224 zwischen den Endpunkten T7 und T8 sowie durch drei Kantenlinien 226, 228 und 230 zwischen den Endpunkten T9 und T10 dargestellt. Im Entwurf 10c gibt es elf Eckpunkte 250 bis 270. Es ist gut zu erkennen, dass die Zwischenräume zwischen den Umrissen 12c, 14c der Leitbahnen bzw. die Zwischenräume zwischen den Leitbahnen auf Kosten der Breite der Umrisse 12c, 14c bzw. der Breite der Leitbahnen automatisch verbreitert wurden, um das Entstehen von Kurzschlüssen zu verringern. Die Anzahl der Eckpunkte hat sich nur um einen Eckpunkt erhöht, so dass die Maskenfertigung aufgrund des Entwurfs 10c im Vergleich zum Entwurf 10 nur unwesentlich aufwendiger ist.

Figur 3 zeigt Verfahrensschritte zur Optimierung eines Entwurfs für die Herstellung einer integrierten Schaltungsanordnung, beispielsweise zum Optimieren des Entwurfs 10 gemäß Figur 1. Das Verfahren beginnt in einem Verfahrensschritt 300 mit der Vorgabe mehrerer Parameter. Beispielsweise wird eine Schrittzählvariable n auf den Wert Eins gesetzt. Eine Konstante zur Angabe der Schrittanzahl N wird beispielsweise auf den Wert Eintausend gesetzt. Ein Gesamtbewertungsmaß GBM wird auf einen sehr kleinen Wert gesetzt, z.B. auf den Wert Minus Zehntausend. Der Wert dieses Gesamtbewertungsmaß GBM soll im Laufe des Verfahrens möglichst groß werden, weil sein Wert umgekehrt proportional mit der Höhe der zu erwartenden Kosten zusammenhängt. Außerdem werden Wichtungsfaktoren W1 gleich Zwei und W2 gleich Eins vorgegeben, welche die Wichtung eines Bewertungsmaßes für Kurzschlüsse bzw. eines Bewertungsmaßes für Unterbrechungen angeben. Die Vorgabe der Werte im Verfahrensschritt 300 hängt von der Art des zu optimierenden Entwurfs ab. Außerdem wird die Vorgabe der Werte von der Zielrichtung der Optimierung bestimmt, vgl. beispielsweise die Erläuterungen zu den Figuren 1C und 2. -

In einem Verfahrensschritt 302 wird ein zu optimierender Entwurf vorgegeben, z.B. der Entwurf 10 durch die in einer GDS2-Datei enthaltenen Daten. Der Entwurf 10 ist beispielsweise das Ergebnis eines manuellen Entwurfsprozesses oder das Ergebnis einer früheren automatischen Optimierung, das nun nach anderen Kriterien nachoptimiert werden soll. Der vorgegebene Entwurf wird als bisheriger Bestentwurf gespeichert, d.h. als sogenannter "best-ever"-Entwurf.

In einem folgenden Verfahrensschritt 304 wird automatisch durch die das Verfahren ausführende Datenverarbeitungsanlage ein Verschiebungsbereich innerhalb des Entwurfs ausgewählt, z.B. der Verschiebungsbereich 100 oder der Verschiebungsbereich 122. Dabei wird beispielsweise eine Zufallsfunktion berücksichtigt. Außerdem wird im Verfahrensschritt 304 die Größe des Verschiebungsbereiches vorgegeben, beispielsweise ebenfalls unter Berücksichtigung einer Zufallsfunktion innerhalb eines vorgegebenen Größenbereiches.

Anschließend wird in einem Verfahrensschritt 306 eine Versatzrichtung und ein Versatzmaß gewählt, wobei beispielsweise wiederum Zufallsfunktionen berücksichtigt werden. In einem folgenden Verfahrensschritt 308 werden dann Teile des zu optimierenden Entwurfs innerhalb des Verschiebungsbereiches 100, 122 gemäß den im Verfahrensschritt 306 bestimmten Werten versetzt. Das Versetzen wurde oben an Hand der Figur 1B für den Verschiebungsbereich 100 erläutert.

In einem Verfahrensschritt 310 werden aufgrund des veränderten Entwurfs, gegebenenfalls nur unter Berücksichtigung des Verschiebungsbereiches 100 zuzüglich eines geeigneten Randbereiches, ein Bewertungsmaß BM1 für das Auftreten von Kurzschlüssen und ein Bewertungsmaß BM2 für das Auftreten von Unterbrechungen berechnet. Dabei werden sogenannte kritische Gebiete berücksichtigt, die für Defekte einer vorgegebenen Größe gelten.

In einem Verfahrensschritt 312 wird ein Gesamtbewertungsmaß GBM für den aktuell durchgeführten Verfahrensschritt berechnet. Dabei werden die Bewertungsmaße BM1, BM2 sowie die Wichtungsfaktoren W1 und W2 verwendet. Beispielsweise gilt die folgende Formel:

$$\mathtt{GBM(n) \;=\; W1 \;\cdot\; BM1 \;+\; W2 \;\cdot\; BM2.}$$

In einem verfahrensschritt 314 wird das im Verfahrensschritt 312 berechnete Gesamtbewertungsmaß GBM(n) mit dem für den vorhergehenden Verfahrenszyklus berechneten Gesamtbewertungsmaß GBM(n-1) bzw. beim ersten Zyklus mit dem im Verfahrensschritt 300 vorgegebenen Gesamtbewertungsmaß GBM verglichen. Wird festgestellt, dass sich der Wert des Gesamtbewertungsmaßes im aktuellen Zyklus vergrößert hat, so folgt unmittelbar nach dem Verfahrensschritt 314 ein Verfahrensschritt 316, in welchem die Veränderung des Entwurfs übernommen wird. Außerdem wird der im Verfahrensschritt 312 berechnete Wert für das Gesamtbewertungsmaß bei einer Übernahme der Veränderung als für die Durchführung weiterer Zyklen gültiges Gesamtbewertungsmaß vermerkt.

Wird dagegen im Verfahrensschritt 314 festgestellt, dass sich das Gesamtbewertungsmaß GBM nicht vergrößert hat, d.h. das Gesamtbewertungsmaß GBM ist unverändert geblieben oder hat sich verkleinert, so folgt unmittelbar nach dem Verfahrensschritt 314 ein Verfahrensschritt 318.

Im Verfahrensschritt 318 wird nach einem vorgegebenen Verfahren unter Berücksichtigung einer Zufallsfunktion ermittelt, ob die Veränderung des Entwurfs für das weitere Verfahren übernommen werden oder verworfen werden soll. Eine dabei verwendete Funktion ist. z.B. beim sogenannten Metropolis-Verfahren die Funktion:

$$\mathtt{p \;=\; exp\;(-\;\Delta GBM/T),}$$

wobei p die Wahrscheinlichkeit für eine Übernahme, exp die Exponentialfunktion, $\Delta$GBM die Differenz von GBM(n-1) und GBM(n) und T einen Parameter, der mit einer Simulationstemperatur gleichgesetzt werden kann, bezeichnen.

Der Parameter T lässt sich im Verlaufe des Verfahrens beispielsweise gemäß einer der beiden folgenden Formeln verändern;

$$T(n) = T0/(1+\ln n),$$

$$T(n) = T0/(1+n),$$

wobei T0 eine Konstante bezeichnet, die physikalisch mit einer hohen Temperatur gleichgesetzt werden kann, n die Schrittzählvariable und ln den natürlichen Logarithmus bezeichnen.

Mit der Exponentialfunktion wird abhängig von der durch die Veränderung hervorgerufenen Verkleinerung des Gesamtbewertungsmaßes GBM ein Wert p bestimmt, der eine Wahrscheinlichkeit angibt, mit der die Veränderung übernommen werden soll. Mit Hilfe eines Zufallsgenerators wird eine Zahl erzeugt, die zufällig in einem Bereich zwischen Null und Eins liegt. Ist der mit Hilfe des Zufallsgenerators erzeugte Zufallswert kleiner als der mit Hilfe der Funktion bestimmte Wert, so wird übernommen. Ist dagegen der Zufallswert größer als der oder gleich dem aus der Funktion entnommenen Wert, so wird die Veränderung des Entwurfs verworfen. Wird der Entwurf übernommen, so wird auch das im Verfahrensschritt 312 berechnete Gesamtbewertungsmaß für das weitere Verfahren übernommen. Wird dagegen die Veränderung verworfen, so wird das im Verfahrensschritt 312 berechnete Gesamtbewertungsmaß ebenfalls als ungültig verworfen.

Sowohl nach dem Verfahrensschritt 316 als auch nach dem Verfahrensschritt 318 folgt unmittelbar ein Verfahrensschritt 319, in welchem geprüft wird, ob der aktuelle Entwurf ein kleineres Gesamtbewertungsmaß als der Bestentwurf hat. Ist das Gesamtbewertungsmaß des aktuellen Entwurfs kleiner als das Gesamtbewertungsmaß des Bestentwurfs, so wird der aktuelle Entwurf als Bestentwurf übernommen. Ist dagegen das Gesamtbewertungsmaß des aktuellen Entwurfs nicht kleiner als das Gesamtbewertungsmaß des Bestentwurfs, so wird der aktuelle Entwurf nicht als Bestentwurf übernommen, so dass sich der Bestentwurf nicht verändert.

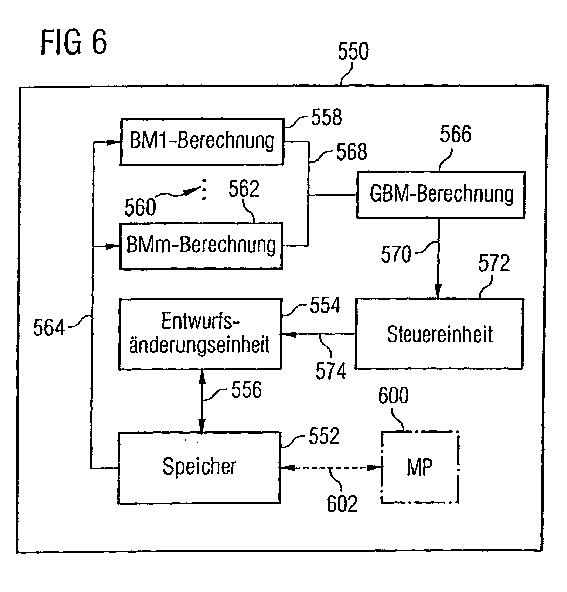

In einem dem Verfahrensschritt 319 folgenden Verfahrensschritt 320 wird geprüft, ob der Wert der Schrittzählvariable n bereits den Wert der vorgegebenen Schrittanzahl N erreicht hat. Ist dies noch nicht der Fall, so folgt unmittelbar nach dem Verfahrensschritt 320 ein Verfahrensschritt 322. Im Verfahrensschritt 322 wird der Wert der Schrittzählvariable n um den Wert Eins erhöht. Außerdem wird kontinuierlich oder gemäß einem anderen geeigneten Verfahren die Trennschärfe der unten an Hand der Figur 6 erläuterten Funktion erhöht. Dadurch erhöht sich auch die Trennschärfe bei der Zufallsauswahl. Die Wahrscheinlichkeit zur Übernahme von Verschlechterungen des Entwurfs sinkt mit zunehmender Anzahl von Verfahrenszyklen.

Nach der Ausführung des Verfahrensschritts 322 wird das Verfahren im Verfahrensschritt 304 mit einem neuen Zyklus fortgesetzt. Das Verfahren befindet sich nun in einer Verfahrensschleife aus den Verfahrensschritten 304 bis 322, die so lange durchlaufen wird, bis im Verfahrensschritt 320 festgestellt wird, dass die Schrittzählvariable n den Wert der Schrittanzahl N erreicht hat. In diesem Fall folgt unmittelbar nach dem Verfahrensschritt 320 ein Verfahrensschritt 324, in dem das Optimierungsverfahren beendet wird. Der als Bestentwurf gespeicherte Entwurf wird als Ergebnis ausgegeben, z.B. in eine Datei.

Das Verfahren lässt sich alternativ oder kumulativ zu der eben erläuterten Abbruchsmöglichkeit auch beenden, wenn die Änderung des Gesamtbewertungsmaßes GBM über k Zyklen ein vorgegebenes Limit unterschreitet, wobei k eine natürliche Zahl größer Zwei ist, z.B. 100. Insbesondere bei größeren k Werten muss davon ausgegangen werden, dass eine "stabile" Lösung erreicht worden ist.

Das an Hand der Figur 3 erläuterte optimierungsverfahren ist eine Art des simulierten Abkühlens, das gewährleistet, dass bei der Maximierung des Gesamtbewertungsmaßes GBM nicht nur ein lokales Maximum, sondern das globale Maximum gefunden wird. Das bedeutet, dass abhängig von den Vorgaben im Verfahrensschritt 300 tatsächlich der optimale Entwurf und nicht nur ein suboptimaler Entwurf ermittelt wird.

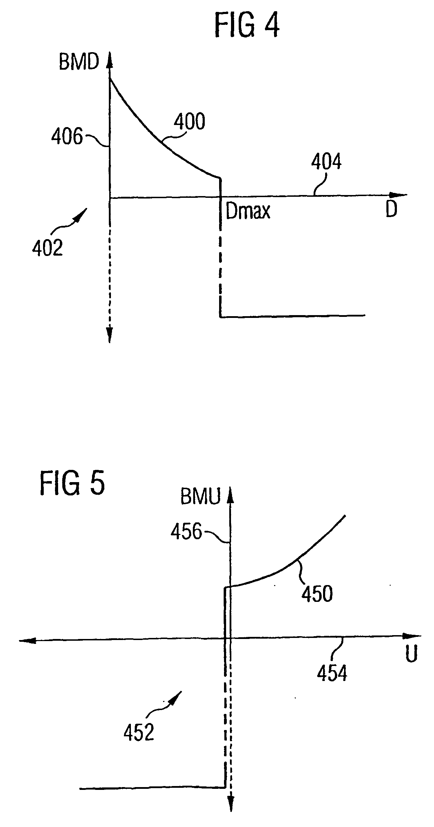

Figur 4 zeigt den Verlauf einer Bewertungsfunktion 400, die bei einem anderen Ausführungsbeispiel zusätzlich für die Ermittlung eines Bewertungsmaßes BMD zur Bewertung der Stromdichte D in dem geänderten Entwurf herangezogen wird. Die Bewertungsfunktion 400 ist in einem Koordinatensystem 402 dargestellt, das eine x-Achse 404 zur Darstellung der Werte der Stromdichte D und eine y-Achse 406 zur Darstellung der Werte des Bewertungsmaßes BMD hat. Im Bereich von sehr kleinen Stromdichten D bis zu einer maximalen Stromdichte Dmax fällt der Wert des Bewertungsmaßes MD von sehr großen positiven Werten auf einen kleinen positiven Wert gemäß einer fallenden Exponentialfunktion ab. Das Überschreiten der maximalen Stromdichte Dmax wird "bestraft" durch die Wahl eines sehr großen negativen Wertes für das Bewertungsmaß BMD, weil es sich um eine Verletzung einer Entwurfsregel handelt. Die Stromdichte D wird im Verfahrensschritt 310 für eine Struktur berechnet, die mit Hilfe des geänderten Entwurf hergestellt werden soll. Danach wird für die berechnete Stromdichte D mit Hilfe der Bewertungsfunktion 400 der zugehörige Wert des Bewertungsmaßes D ermittelt und bei der Berechnung des Gesamtbewertungsmaßes GBM mit einem Wichtungsfaktor W3 gewichtet.

Figur 5 zeigt den Verlauf einer Bewertungsfunktion 450 für die Überlappung U einer Leitbahn mit einem darunterliegenden Kontaktloch. Die Bewertungsfunktion 450 ist in einem Koordinatensystem 452 dargestellt, das eine x-Achse 454 zur Darstellung des Wertes der Überlappung U und eine y-Achse 456 zur Darstellung der Werte eines Bewertungsmaßes BMU zur Bewertung der Überlappung hat. Die Werte der Überlappung U können auch negativ werden, wenn keine Überlappung oder ein Abstand quer zur eigentlichen Überlappungsrichtung auftritt. Das Bewertungsmaß BMU hat für negative Werte der Überlappung U einen großen negativen Wert. Für kleine Überlappungen U hat das Bewertungsmaß BMU einen kleinen positiven Wert. Mit steigender Überlappung U steigt die Bewertungsfunktion 450 dann gemäß einer Exponentialfunktion an.

Das Bewertungsmaß BMU wird bei einem nächsten Ausführungsbeispiel im Verfahrensschritt 310 zur Berechnung des Gesamtbewertungsmaßes GBM herangezogen. Ein Wichtungsfaktor W4 dient zur Wichtung des Bewertungsmaßes BMU.

Figur 6 zeigt Funktionseinheiten einer elektronischen Schaltung 550, die zum Optimieren des Entwurfs 10 und damit zum Ausführen der an Hand der Figur 3 erläuterten Verfahrensschritte dient. Die Schaltung 550 enthält gemäß einem Ausführungsbeispiel keinen Prozessor, sondern nur Logikschaltungen.

Der Entwurf 10 wird in einer Speichereinheit 552 gespeichert. Eine Entwurfsänderungseinheit 554 dient zum Ändern des Entwurfs in einem Verschiebebereich 106, 122. Die Entwurfsänderungseinheit 554 greift über ein Bussystem 556 auf die Speichereinheit 552 bidirektional zu. Bewertungsmaßberechnungseinheiten 558 bis 562 dienen zur Berechnung von Bewertungsmaßen BM1 bis BMm, wobei m eine natürliche Zahl zur Bezeichnung des letzten Bewertungsmaßes ist. Die Bewertungsmaßberechnungseinheiten 558 bis 562 lesen die im Speicher 552 gespeicherten Daten des veränderten Entwurfs, z.B. 10a, über ein Bussystem 564.

Das Gesamtbewertungsmaß GBM wird in einer Gesamtbewertungsmaß-Berechnungseinheit 566 berechnet, die über Leitungen 568 eingangsseitig mit Ausgängen der Bewertungsmaßberechnungseinheiten 558 bis 562 verbunden ist. Die Berechnungseinheit 566 führt die in Figur 3 für den Verfahrensschritt 312 erläuterte Berechnung des Gesamtbewertungsmaßes durch. Die Berechnungseinheit 566 gibt das berechnete Gesamtbewertungsmaß GBM über eine Leitung 570 an eine Steuereinheit 572 aus, die zur Steuerung des Optimierungsverfahrens dient.

Die Steuereinheit 572 steuert die anderen Einheiten der Schaltung 550, siehe beispielsweise Steuerleitung 574 zur Steuerung der Entwurfsänderungseinheit 554. Über die Steuerleitung 574 wird beispielsweise die Lage eines Verschiebebereiches, z.B. 100, 122, die Richtung, z.B. 108, der Verschiebung und das Verschiebungsmaß vorgegeben.

Bei einem anderen Ausführungsbeispiel enthält die Schaltung 550 auch einen Prozessor 600, der Befehle eines Programms ausführt, das in der Speichereinheit 552 gespeichert ist. Der Prozessor 600 greift auf die Speichereinheit 552 über ein Bussystem 602 zu. Bei der Verwendung des Prozessors 600 werden die Funktionen der Entwurfsänderungseinheit 554, der Bewertungsmaßberechnungseinheiten 558 bis 562, der GBM-Berechnungseinheit 566 und der Steuereinheit 572 beim Ausführen der Befehle des Programms erbracht. An Stelle der Leitungen 568, 570 und 574 werden Übergaben von Parametern in Speicherzellen zum Datenaustausch genutzt.

Während die Verfahrensschritte 316 und 318 für das sogenannte Metropolis-Verfahren des simulierten Abkühlens gelten, wird bei einem nächsten Ausführungsbeispiel sowohl im Verfahrensschritt 316 als auch im Verfahrensschritt 318 eine Zufallsentscheidung abhängig von der Differenz der Gesamtbewertungsmaße getroffen. Als Funktion zum Bestimmen des Vergleichswertes für den Zufallswert, ist bspw. Sigmoidfunktionen geeignet, deren Steilheit vom Wert der Temperatur T abhängt.

Bei einem anderen Ausführungsbeispiel wird an Stelle des Optimierungsverfahrens "simuliertes Abkühlen" ein anderes Optimierungsverfahren eingesetzt:

- beispielsweise wird die Verschiebung ermittelt, die zu der größten Verbesserung des Gesamtbewertungsmaßes GBM in jedem Verfahrenszyklus führt. Ein solches Verfahren ist als Verfahren zur Berechnung des größten Anstieges bzw. Abstieges bekannt (steepest-descent method),
- oder ein sogenannter genetischer Algorithmus, bei dem der Entwurfsbereich aus einem anderen Entwurf gemäß vorgegebener Kriterien übernommen wird, oder
- eine Kombination der genannten Optimierungsverfahren.

Bei einem weiteren Ausführungsbeispiel wird das Gesamtbewertungsmaß verkleinert, um den Entwurf zu verbessern. Dafür ist es erforderlich, die Bewertungsfunktionen so zu wählen, dass Verbesserungen des Entwurfs zu kleineren Bewertungsmaßen führen.

**Patentansprüche**

**1.** Verfahren zum Verändern von Entwurfsdaten für die Herstellung eines Bauteils, insbesondere einer integrierten Schaltungsanordnung,

bei dem Entwurfsdaten vorgegeben werden (302), die einen zu verändernden geometrischen Entwurf (10) für ein Bauteil festlegen,

bei dem aus den Entwurfsdaten veränderte Entwurfsdaten erzeugt und gespeichert werden (308), die einen im Vergleich zu dem geometrischen Entwurf (10) der Entwurfsdaten in einem Bereich (100) lokal veränderten geometrischen Entwurf (10a) festlegen,

bei dem aus den veränderten Entwurfsdaten (10a) für den veränderten Entwurf (10a) ein Bewertungsmaß (BM1, GBM) ermittelt wird (312),

wobei beim Ermitteln des Bewertungsmaßes eine für den veränderten Entwurf oder Bereich (100) ermittelte kritische Fläche bezüglich Kurzschlüssen und/oder eine für den veränderten Entwurf (10a) oder in dem Bereich (100) ermittelte kritische Fläche bezüglich Unterbrechungen ermittelt wird (310),

bei dem das Bewertungsmaß (GBM) für den veränderten Entwurf (10a) mit einem Bewertungsmaß (BM1, GBM) für den zu verändernden Entwurf (10) verglichen wird (314),

bei dem abhängig vom Vergleichsergebnis die unveränderten Entwurfsdaten beibehalten oder durch die veränderten Entwurfsdaten ersetzt werden (316, 318),

wobei automatisch mehrere Zyklen von Veränderungen, vergleichen und Entscheidungen über das Ersetzen durchgeführt werden,

und bei dem die kritischen Fläche unter Annahme von Defekten einer vorgegebenen Größenverteilung ermittelt wird, wobei die Größenverteilung so gewählt wird, dass bei der Herstellung des Bauelementes auftretende Defekte nachgebildet werden.

2. verfahren nach Anspruch 1, bei dem ein Bereich (100) für die lokale Veränderung und/oder die Größe dieses Bereiches (100) ohne Nutzung einer Zufallsfunktion ermittelt wird,
oder ein Bereich (100) für die lokale Veränderung
und/oder die Größe dieses Bereiches unter Nutzung einer Zufallsfunktion ermittelt wird.

3. verfahren nach Anspruch 1 oder 2, bei dem ein Bereich (100) für die lokale Veränderung und/oder die Größe dieses Bereiches (100) gemäß einer Gleichverteilung oder mit einer Begünstigung von Bereichen und/oder Größen ausgewählt wird, die die Veränderung des Bewertungsmaßes (GBM) hin zum Ziel des Verfahrens besonders beeinträchtigen.

4. Verfahren nach einem der vorhergehenden Ansprüche, bei dem für das Erzeugen der veränderten Entwurfsdaten (10a) in dem durch die zu verändernden Entwurfsdaten festgelegten Entwurf ein Bereich (100) ausgewählt wird, Entwurfsdaten ermittelt werden, welche den Entwurf in dem ausgewählten Bereich (100) betreffen, und die ermittelten Entwurfsdaten gemäß einer vorgegebenen Funktion verändert werden, die eine Geometrieveranderunq des Entwurfs in dem ausgewählten Bereich bewirkt.

5. Verfahren nach Anspruch 4, bei dem die Geometrieveränderung eine Verschiebung (308) eines Entwurfsteils in dem Bereich (100) um eine vorgegebene Strecke oder um eine vorgegebene Anzahl von Punkten eines Rastermaßes und in einer vorgegebenen Richtung ist, und/oder die Geometrieveränderung eine Spiegelung eines Entwurfsteils in dem Bereich (100) an einer vorgegebenen Spiegelachse ist,
und/oder die Geometrieveränderung eine Drehung eines Entwurfsteils in dem Bereich (100) um einen vorgegebenen Drehpunkt und einen vorgegebenen Drehwinkel ist,
und/oder die Geometrieveränderung eine gleichmäßige oder ungleichmäßige Dehnung oder Stauchung eines Entwurfsteils in dem Bereich (100) entlang mindestens einer vorgegebenen Richtung und um mindestens einen vorgegebenen Skalierungsfaktor ist,
und/oder die Geometrieveränderung eine Glättung von Linien eines Entwurfsteils in dem Bereich (100) betrifft,
und/oder die Geometrieveränderung ein Ersetzen des Entwurfsteils in dem ausgewählten Bereich (100) durch einen Entwurfsteil aus einem anderen Bereich des Entwurfs oder durch einen vorgegebenen Eritwurfsteil oder durch einen entsprechenden Entwurfsteil eines Entwurf aus einem früheren Zyklus des Verfahrens ist, wobei der entsprechende Bereich an der gleichen Stelle im Entwurf liegt, wie der ausgewählte Bereich oder eine ähnliche Geometrie wie der ausgewählte Bereich hat,
und wobei der entsprechende Bereich vorzugsweise ein Bereich aus dem besten bisher in dem Verfahren ermittelten Entwurf ist,
und/oder die Geometrieveränderung eine Änderung der Gesamtfläche des geänderten Entwurfs (10a) im Vergleich zur Gesamtfläche des zu ändernden Entwurfs (19) bewirkt.

6. Verfahren nach Anspruch 4 oder 5, bei dem mindestens eine Vorgabe für die Geometrieveränderung unter Nutzung einer zufallsfunktion ermittelt wird.

**7.** Verfahren nach einem der vorhergehenden Ansprüche, bei dem beim Ermitteln des Bewertungsmaßes die Anzahl von Ecken (E1 bis E4) oder die Anzahl von Kanten (110 bis 120) in dem veränderten Entwurf (10a) oder in dem Bereich (100) ermittelt wird,
und/oder beim Ermitteln des Bewertungsmaßes die Strombelastbarkeit (D) mindestens einer Struktur ermittelt wird, die mit Hilfe des Entwurfs (10, 10a) hergestellt werden soll,
und/oder beim Ermitteln des Bewertungsmaßes die Koppelkapazität zwischen einem Element einer herzustellenden integrierten Schaltungsanordnung und mindestens einer Struktur ermittelt wird, die mit Hilfe des Entwurfs (10, 10a) hergestellt werden soll,
und/oder beim Ermitteln des Bewertungsmaßes die Überlappung (U) zwischen einem Element einer herzustellenden integrierten Schaltungsanordnung und mindestens einer Struktur ermittelt wird, die mit Hilfe des Entwurfs (10, 10a) hergestellt werden soll,
und/oder beim Ermitteln des Bewertungsmaßes die Gesamtfläche des geänderten Entwurfs (10a) berechnet wird.

**8.** Verfahren nach einem der vorhergehenden Ansprüche, bei dem das Bewertungsmaß ein Gesamtbewertungsmaß (GBM) ist, das aus mindestens zwei verschiedenen Bewertungsmaßen (BM1, BM2) ermittelt wird, und/oder Wichtungsfaktoren (W1, W2) mit voneinander verschiedenen Werten vorgegeben und zur Wichtung der Bewertungsmaße (BM1, BM2) bei der Ermittlung des Gesamtbewertungsmaßes (GBM) verwendet werden.

**9.** Verfahren nach einem der vorhergehenden Ansprüche, bei dem eine Entscheidung über das Beibehalten und/oder das Ersetzen der unveränderten Entwurfsdaten abhängig von einer Zufallsfunktion durchgeführt wird (316, 318).

**10.** Verfahren nach Anspruch 9, bei dem die Abhängigkeit der Entscheidung von der Zufallsfunktion abhängig von der Anzahl der Zyklen (n) verringert wird.

**11.** verfahren nach einem der vorhergehenden Ansprüche, bei dem für einen Entwurf (10, 10a) ein Rastermaß gewählt wird, das gleich der Breite eines Maskenschreibstrahls ist, der zur Übertragung des Entwurfs (10, 10a) auf eine Lithografiemaske genutzt wird,
oder dass für einen Entwurf (10, 10a) ein Rastermaß gewählt wird, das kleiner als die Breite des Maskenschreibstrahls ist.

**12.** Datenverarbeitungsanlage (550) zum automatischen Verändern von Entwurfsdaten für die Herstellung eines Bauteils, insbesondere einer integrierten Schaltungsanordnung,
mit einer Speichereinheit (552) zum Speichern von zu verändernden Entwurisdaten, die einen zu verändernden geometrischen Entwurf (10) für ein Bauteil festlegen,
mit einer Anderungseinheit (S54), die aus den Entwurfsdaten veränderte Entwurfsdaten eines veränderten Entwurfs (10a) erzeugt und in der Speichereinheit (552) speichert,
mit einer Bewertungsmaßermittlungseinheit (558 bis 562), die aus den veränderten Entwurfsdaten ein Bewertungsmaß (GBM) ermittelt,
wobei beim Ermitteln des Bewertungsmaßes eine für den veränderten Entwurf oder Bereich (100) ermittelte kritische Fläche bezüglich Kurzschlüssen und/oder eine für den veränderten Entwurf (10a) oder in dem Bereich (100) ermittelte kritische Fläche bezüglich Unterbrechungen ermittelt wird (310),
mit einer Vergleichseinheit, die das Bewertungsmaß (GBM) für den veränderten Entwurf (10a) mit einem Bewertungsmaß für den zu verändernden Entwurf vergleicht,
und mit einer Steuereinheit (572), die abhängig von dem Vergleichsergebnis die unveränderten Entwurfsdaten beibehält oder durch die veränderten Entwurfsdaten ersetzt,
und die automatisch die Durchführung mehrerer Zyklen von Veränderungen, Vergleichen und Entscheidungen über das Ersetzen veranlasst,
wobei die kritischen Fläche unter Annahme von Defekten einer vorgegebenen Größenverteilung ermittelt wird und wobei die Größenverteilung so gewählt wird, dass bei der Herstellung des Bauelementes auftretende Defekte nachgebildet werden.

**13.** Datenverarbeitungsanlage (550) nach Anspruch 12 mit mindestens einer weiteren Einheit, bei deren Betrieb ein Verfahren nach einem der Ansprüthe 1 bis 11 ausgeführt wird.

**14.** Programm oder Datenspeicher mit einem Programm, das eine Befehlsfolge enthält, bei deren Ausführung durch einen Prozessor (600) ein Verfahren nach einem der Ansprüche 1 bis 11 ausgeführt wird.

**Claims**

1. Method for altering design data for producing a component, particularly an integrated circuit arrangement,
in which design data are prescribed (302) which stipulate a geometrical design (10) which is to be altered for a component,
in which the design data are used to produce altered design data which are stored (308) and stipulate a geometrical design (10a) which is altered locally in comparison with the geometrical design (10) of the design data in a region (100),
in which the altered design data (10a) are used to ascertain (312) an assessment criterion (BM1, GBM) for the altered design (10a),
where the ascertainment of the assessment criterion involves ascertaining (310) a critical area for short circuits, which area is ascertained for the altered design or region (100), and/or a critical area for interruptions, which area is ascertained for the altered design (10a) or in the region (100),
in which the assessment criterion (GBM) for the altered design (10a) is compared (314) with an assessment criterion (BM1, GBM) for the design (10) which is to be altered,
in which the unaltered design data are retained or replaced (316, 318) with the altered design data depending on the comparison result,
with a plurality of cycles of alterations, comparisons and decisions about replacement being performed automatically,
and in which the critical area is ascertained assuming defects in a prescribed size distribution, the size distribution being chosen such that defects which arise during the production of the eomponent are simulated.

2. Method according to Claim 1, in which a region (100) for the local alteration and/or the size of this region (100) is/are ascertained without using a random function,
or a region (100) for the local alteration and/or the size of this region is/are ascertained using a random function.

3. Method according to Claim 1 or 2, in which a region (100) for the local alteration and/or the size of this region (100) is/are selected on the basis of an even distribution or by favouring regions and/or sizes which particularly impair the alteration of the assessment criterion (GBM) towards the aim of the method.

4. Method according to one of the preceding claims,
in which a region (100) is selected for producing the altered design data (10a) in the design stipulated by the design data which are to be altered,
design data are ascertained which relate to the design in the selected region (100),
and the ascertained design data are altered on the basis of a prescribed function which brings about a geometrical alteration of the design in the selected region.

5. Method according to Claim 4, in which the geometrical alteration is relocation (308) of a design part in the region (100) by a prescribed distance or by a prescribed number of points of a grid dimension and in a prescribed direction,
and/or the geometrical alteration is mirror imaging of a design part in the region (100) on a prescribed mirror axis,
and/or the geometrical alteration is rotation of a design part in the region (100) about a prescribed centre of rotation and through a prescribed angle of rotation,
and/or the geometrical alteration is uniform or nonuniform expansion or contraction of a design part in the region (100) in at least one prescribed direction and by at least one prescribed scaling factor,
and/or the geometrical alteration relates to smoothing of lines of a design part in the region (100),
and/or the geometrical alteration is replacement of the design part in the selected region (100) with a design part from another region of the design or with a prescribed design part or with a corresponding design part of a design from an earlier cycle of the method, the corresponding region being situated at the same location in the design as the selected region or having a similar geometry to the selected region,
and the corresponding region preferably being a region from the best design ascertained in the method to date,
and/or the geometrical alteration brings about a change to the total area of the changed design (10a) in comparison with the total area of the design (19) which is to be changed.

6. Method according to Claim 4 or 5, in which at least one stipulation for the geometrical alteration is ascertained using a random function.

7. Method according to one of the preceding claims,
in which the ascertainment of the assessment criterion involves ascertaining the number of corners (E1 to E4) or the number of edges (110 to 120) in the altered design (10a) or in the region (100),
and/or the ascertainment of the assessment criterion involves ascertaining the current-carrying capacity (D) of at least one structure which is to be produced using the design (10, 10a),

and/or the ascertainment of the assessment criterion involves ascertaining the coupling capacitance between an element of an integrated circuit arrangement which is to be produced and at least one structure which is to be produced using the design (10, 10a),

and/or the ascertainment of the assessment criterion involves ascertaining the overlap (U) between an element of an integrated circuit arrangement which is to be produced and at least one structure which is to be produced using the design (10, 10a),

and/or the ascertainment of the assessment criterion involves calculating the total area of the changed design (10a).

8. Method according to one of the preceding claims,

in which the assessment criterion is an overall assessment criterion (GBM) which is ascertained from at least two different assessment criterion (BM1, BM2),

and/or weighting factors (W1, W2) with different values are prescribed and are used for weighting the assessment criteria (BM1, BM2) when ascertaining the overall assessment criterion (GBM).

9. Method according to one of the preceding claims,

in which a decision about retaining and/or replacing the unaltered design data is made (316, 318) on the basis of a random function.

10. Method according to Claim 9, in which the dependency of the decision on the random function is reduced on the basis of the number of cycles (n).

11. Method according to one of the preceding claims,

in which a design (10, 10a) has a grid dimension chosen for it which is equal to the width of a mask writing beam which is used for transferring the design (10, 10a) onto a lithographic mask,

or a design (10, 10a) has a grid dimension chosen for it which is less than the width of the mask writing beam.

12. Data processing installation (550) for automatically altering design data for producing a component, particularly an integrated circuit arrangement,

having a memory unit (552) for storing design data which are to be altered and stipulate a geometrical design (10) which is to be altered for a component,

having a change unit (554) which uses the design data to produce altered design data for an altered design (10a) and stores them in the memory unit (552),

having an assessment criterion ascertainment unit (558 to 562) which ascertains an assessment criterion (GBM) from the altered design data,

where the ascertainment of the assessment criterion involves ascertaining (310) a critical area for short circuits, which area is ascertained for the altered design or region (100), and/or a critical area for interruptions, which area is ascertained for the altered design (10a) or in the region (100),

having a comparison unit which compares the assessment criterion (GBM) for the altered design (10a) with an assessment criterion for the design which is to be altered,

and having a control unit (572) which retains the unaltered design data or replaces them with the altered design data depending on the comparison result,

and which automatically prompts the performance of a plurality of cycles of alterations, comparisons and decisions about replacement,

the critical area being ascertained assuming defects in a prescribed size distribution, and the size distribution being chosen such that defects which arise during the production of the component are simulated.

13. Data processing installation (550) according to Claim 12, having at least one further unit whose operation involves carrying out a method according to one of Claims 1 to 11.

14. Program or data store having a program which contains a command sequence whose execution by a processor (600) involves carrying out a method according to one of Claims 1 to 11.

**Revendications**

1. Procédé de modification de données de projet pour la fabrication d'un composant, en particulier d'un circuit intégré, dans lequel

on prédétermine des données de projet (302) qui définissent un projet géométrique (10) à modifier pour un composant,

on génère et on mémorise (308) à partir des données de projet des données de projet modifiées qui définissent un projet géométrique (10a) modifié localement dans une région (100) par rapport au projet géométrique (10) des données de projet,

on détermine à partir des données de projet modifiées (10a) une mesure d'évaluation (BM1, GBM) pour le projet modifié (10a),

on détermine (310), lors de la détermination de la valeur d'évaluation, une surface critique pour les courts-circuits qui est déterminée pour le projet modifié ou la région (100) et/ou une surface critique pour des coupures qui est déterminée pour le projet modifié (10a) ou dans la région (100),

on compare (314) la mesure d'évaluation (GBM) pour le projet modifié (10a) à une valeur d'évaluation (BM1, GBM) pour le projet (10) à modifier,

en fonction du résultat de la comparaison, on conserve les données de projet non modifiées ou on les remplace par les données de projet modifiées (316, 318),

on réalise automatiquement plusieurs cycles de modifications, de comparaison et de décision du remplacement, et

on détermine la surface critique en supposant des défauts dans une répartition de dimension prédéterminée, la répartition de dimension étant choisie de façon à simuler des défauts survenant lors de la fabrication du composant.

2. Procédé selon la revendication 1, dans lequel on détermine une région (100) pour la modification locale et/ou la dimension de cette région (100) sans utiliser de fonction aléatoire, ou dans lequel on détermine une région (100) pour la modification locale et/ou la dimension de cette région en utilisant une fonction aléatoire.

3. Procédé selon la revendication 1 ou 2, dans lequel on choisit une région (100) pour la modification locale et/ou la dimension de cette région (100) selon une répartition uniforme ou un traitement préférentiel de régions et/ou de dimensions qui compromettent de façon particulière la modification de la valeur d'évaluation (GBM) dans le sens du procédé.

4. Procédé selon l'une des revendications précédentes, dans lequel
on choisit une région (100) dans le projet déterminé par les données de projet à modifier pour générer les données de projet modifiées (10a),
on détermine des données de projet qui concernent le projet dans la région choisie (100), et
on modifie les données de projet déterminées selon une fonction prédéterminée qui génère une modification géométrique du projet dans la région choisie.

5. Procédé selon la revendication 4, dans lequel
la modification géométrique est une translation (308) d'une partie de projet dans la région (100) d'une étendue prédéterminée ou d'un nombre prédéterminé de points d'une dimension de trame et dans une direction déterminée, et/ou
la modification géométrique est une symétrie d'une partie de projet dans la région (100) par rapport un axe de symétrie prédéterminé, et/ou
la modification géométrique est une rotation d'une partie de projet dans la région (100) autour d'un point de rotation prédéterminé et d'un angle dé rotation prédéterminé, et/ou
la modification géométrique est une dilatation ou une compression uniforme ou non uniforme d'une partie de projet dans la région (100) dans au moins une direction prédéterminée et d'au moins un facteur d'échelle prédéterminé, et/ou
la modification géométrique est un lissage de lignes d'une partie de projet dans la région (100), et/ou
la modification géométrique est un remplacement de la partie de projet dans la région choisie (100) par une partie de projet venant d'une autre région du projet ou par une partie de projet prédéterminée ou par une partie de projet correspondante d'un projet provenant d'un cycle précédent du procédé, la région correspondante se trouvant au même emplacement dans le projet que la région choisie ou ayant une géométrie similaire à celle de la région choisie, et
la région correspondante étant avantageusement une région provenant du meilleur projet déterminé jusqu'à présent dans le procédé, et/ou
la modification géométrique génère une modification de la surface totale du projet modifié (10a) en comparaison avec la surface totale du projet à modifier (19).

6. Procédé selon la revendication 4 ou 5, dans lequel au moins une directive pour la modification géométrique est déterminée en utilisant une fonction aléatoire.

**7.** Procédé selon l'une des revendications précédentes, dans lequel on détermine, lors de la détermination de la mesure d'évaluation, le nombre de coins (E1 à E4) ou le nombre de bords (110 à 120) dans le projet modifié (10a) ou dans la région (100), et/ou

on détermine, lors de la détermination de la valeur d'évaluation, on détermine l'intensité maximale admissible d'au moins une structure qui est réalisée à l'aide du projet (10, 10a), et/ou

on détermine, lors de la détermination de la valeur d'évaluation, la capacité de couplage entre un élément d'un circuit intégré à fabriquer et au moins une structure qui est réalisée à l'aide du projet (10, 10a), et/ou

on détermine, lors de la détermination de la valeur d'évaluation, le recouvrement entre un élément d'un circuit intégré à fabriquer et au moins une structure qui est réalisée à l'aide du projet (10, 10a), et/ou

on calcule, lors de la détermination de la valeur d'évaluation, la surface totale du projet modifié (10a).

**8.** Procédé selon l'une des revendications précédentes, dans lequel
la valeur d'évaluation est une valeur d'évaluation totale (GBM) qui est déterminée à partir d'au moins deux valeurs d'évaluation différentes (BM1, BM2), et/ou

on prédétermine des facteurs de pondération (W1, W2) de valeurs différentes que l'on utilise pour la pondération des valeurs d'évaluation (BM1, BM2) lors de la détermination de la valeur d'évaluation totale (GBM).

**9.** Procédé selon l'une des revendications précédentes, dans lequel une décision de conservation et/ou de remplacement des données de projet non modifiées est effectuée en relation avec une fonction aléatoire (316, 318).

**10.** Procédé selon la revendication 9, dans lequel la relation entre la décision et la fonction aléatoire est réduite en fonction du nombre de cycles.

**11.** Procédé selon l'une des revendications précédentes, dans lequel on choisi pour un projet (10, 10a) une dimension de trame qui est égale à la largeur d'un faisceau traceur de masque qui est utilisé pour la transmission du projet (10, 10a) sur un masque lithographique, ou dans lequel on choisit pour un projet (10, 10a) une dimension de trame qui est inférieure à la largeur du faisceau traceur de masque.

**12.** Système de traitement de données (550) destiné à modifier automatiquement des données de projet pour la fabrication d'un composant, en particulier d'un circuit intégré, lequel le système comporte
une unité de mémorisation (552) destinée à mémoriser des données de projet à modifier qui définissent un projet géométrique à modifier (10) pour un composant,
une unité de modification (554) qui génère à partir des données de projet des données de projet modifiées d'un projet modifié (10a) qu'elle mémorise dans l'unité de mémorisation (552),
une unité de détermination de valeur d'évaluation (558 à 562,) qui détermine une valeur d'évaluation (GBM) à partir des données de projet modifiées,
une surface critique pour les courts-circuits qui est déterminée pour le projet modifié ou la région (100) et/ou une surface critique pour des coupures qui est déterminée pour le projet modifié (10a) ou dans la région (100) étant déterminées lors de la détermination de la valeur d'évaluation,
une unité de comparaison qui compare la valeur d'évaluation (GBM) pour le projet modifié (10a) à une valeur d'évaluation pour le projet à modifier, et
une unité de commande (572) qui conserve, en fonction du résultat de la comparaison, les données de projet non modifiées ou qui les remplace par les données de projet modifiées,
et qui ordonne automatiquement la réalisation de plusieurs cycles de modification, de comparaison et de décision du remplacement,
la surface critique étant déterminée en supposant des défauts dans une répartition de dimension prédéterminée et la répartition de dimension étant choisie de façon à simuler des défauts survenant lors de la fabrication du composant.

**13.** Système de traitement de données (550) selon la revendication 12, comportant au moins une autre unité pendant le fonctionnement de laquelle est mis en oeuvre un procédé selon l'une des revendications 1 à 11.

**14.** Programme ou mémoire de données comportant un programme qui contient une succession d'instructions pendant la réalisation desquelles un procédé selon l'une des revendications 1 à 11 est mis en oeuvre au moyen d'un processeur (600).

FIG 1A

FIG 1B

## FIG 1C

## FIG 2

FIG 3

$n=1$, GBM $=10000$
$w1=2$, W2 $=1$ usw.

Start ~300

Vorgabe eines Entwurfs
Bestentwurf ~302

Wahl eines Rechtecks ~304

Wahl eines Versatzes ~306

lokales Versetzen
des Entwurfs ~308

Simulation ~310

$$GBM(n) = f(BM1,BM2,W1,W2)$$ ~312

GBM(n)GBM(n-1)? ~314

nein

ja

Übernahme ~316

Übernahme abh.
von ΔGBM und
Zufallsfunktion ~318

319

Bestentwurf ggf. ändern

n=N? ~320

nein

ja

$n=n+1$ und
Trennschärfe
der
Zufallsauswahl
erhöhen ~322

Ende ~324

# FIG 4

# FIG 5

## FIG 6

550

```
┌────────────────────────────────────────────────────────────────┐
│                                                                  │
│       ┌──────────────────┐  ⌐558                                │
│   ┌──▶│  BM1-Berechnung  │      ⌐568          566                │
│   │   └──────────────────┘                                       │
│   │          ⋮   562              ┌──────────────────┐           │
│   │    560 ⟶                      │ GBM-Berechnung   │           │
│   │   ┌──────────────────┐        └──────────────────┘           │
│   └──▶│  BMm-Berechnung  │              570⌐      572             │
│   │   └──────────────────┘                  │                    │
│   │                                         ▼                    │
│ 564⌐  ┌──────────────────┐ ⌐554   ┌──────────────────┐           │
│   │   │    Entwurfs-     │◀───────│   Steuereinheit  │           │
│   │   │  änderungseinheit│   574  └──────────────────┘           │
│   │   └──────────────────┘                                       │
│   │            ↕  ⌐556              600                           │
│   │   ┌──────────────────┐ ⌐552    ┌ ─ ─ ─ ─ ┐                   │
│   └──▶│     Speicher     │◀ ─ ─ ─ ▶   MP                         │
│       └──────────────────┘    602  └ ─ ─ ─ ─ ┘                   │
│                                                                  │
└────────────────────────────────────────────────────────────────┘
```